# EUROPÄISCHE PATENTSCHRIFT

(11) **EP 1 179 410 B1**
(45) Veröffentlichungstag und Bekanntmachung des Hinweises auf die Patenterteilung: **10.12.2003**
(21) Anmeldenummer: 01112266.0
(22) Anmeldetag: 18.05.2001
(51) Int. Cl.: B29C 65/34, F16L 47/02

(54) **Verfahren zum Messen der Schweissspannung an einer Heizwendel eines Heizwendelfittings sowie Heizwendel-Schweissvorrichtung hierfür**
Method for measuring the welding voltage in a heating coil of a heating coil fitting and heating coil welding apparatus therefore
Procédé pour mesurer la tension de soudage sur un filament chauffant d'un dispositif de soudage et dispositif de soudage à filament chauffant

(30) Priorität: 10.08.2000 DE 10039192
(43) Veröffentlichungstag der Anmeldung: 13.02.2002
(73) Patentinhaber: PF Schweisstechnologie GmbH, 36304 Alsfeld (DE)
(72) Erfinder: Spychalski-Merle, Achim, 36304 Alsfeld (DE); Merle, Bernd, 36304 Alsfeld (DE)
(74) Vertreter: Fritsche, Rainer, Dipl.-Wirtsch.-Ing.

(56) Entgegenhaltungen:
- GB-A- 2 137 026
- US-A- 4 486 650
- PATENT ABSTRACTS OF JAPAN vol. 1999, no. 13, 30. November 1999 (1999-11-30) & JP 11 216777 A (SEKISUI CHEM CO LTD), 10. August 1999 (1999-08-10)
- PATENT ABSTRACTS OF JAPAN vol. 1995, no. 04, 31. Mai 1995 (1995-05-31) & JP 07 016930 A (TOKUSHU KOGYO KK), 20. Januar 1995 (1995-01-20)
- PATENT ABSTRACTS OF JAPAN vol. 017, no. 362 (M-1441), 8. Juli 1993 (1993-07-08) & JP 05 052288 A (SEKISUI CHEM CO LTD), 2. März 1993 (1993-03-02)
- PATENT ABSTRACTS OF JAPAN vol. 015, no. 190 (M-1113), 16. Mai 1991 (1991-05-16) & JP 03 047737 A (MITSUI PETROCHEM IND LTD), 28. Februar 1991 (1991-02-28)
- PATENT ABSTRACTS OF JAPAN vol. 2000, no. 01, 31. Januar 2000 (2000-01-31) & JP 11 291355 A (KUBOTA CORP), 26. Oktober 1999 (1999-10-26)

## Beschreibung

Die vorliegende Erfindung betrifft ein Verfahren zum Messen der Schweißspannung an der Heizwendel eines Heizwendelfittings gemäß dem Oberbegriff des Anspruchs 1 sowie eine Heizwendel-Schweißvorrichtung, die insbesondere zum Durchführen des vorstehend erwähnten Verfahrens geeignet ist, gemäß dem Oberbegriff des Anspruchs 5.

Vergleichbare Verfahren zum Messen der Schweißspannung an einer Heizwendel eines Heizwendelfittings und Heizwendel-Schweifsvorrichtungen sind z.B. aus der JP-A-11-216 777, der JP-A-03-047 737 oder der JP-A-11-291 355 bekannt.

Um Kunststoffinstallationsbauteile, wie beispielsweise Rohre, dicht zu verbinden, werden in der Praxis Heizwendelfittinge eingesetzt. Diese weisen ein aus Kunststoff hergestelltes Fittingrohr auf, in dessen Rohrwand wenigstens eine Heizwendel angeordnet ist. Über zwei nach außen geführte Anschlußenden, die in Anschlußelementen enden, ist die Heizwendel mit einer elektrischen Schweißstrom-Versorgungseinheit verbindbar. Zum Verschweißen der beiden Installationsrohre aus Kunststoff werden diese in das Fittingrohr eingeschoben, das einen Innendurchmesser aufweist, der geringfügig größer ist als der Außendurchmesser der beiden miteinander zu verbindenen Rohre. Anschließend wird ein elektrischer Strom der Heizwendel zugeführt, wobei die zugeführte Energie in Folge des der Heizwendel innewohnenden elektrischen Widerstandes in Wärme umgesetzt wird. Diese durchdringt langsam, von der Heizwendel ausgehend, die Kunststoffmaterialien der Rohre und des Fittings. Bei Überschreiten des Erweichungspunktes bzw. des Schmelzbereiches plastifizieren bzw. erweichen diese Materialien und fließen ineinander. Beim Erkalten härten sie dann als gas- bzw. flüssigdichte Verbindung zwischen den beiden Rohren und dem Fitting aus. Für diesen Vorgang wird auch der Begriff "Heizwendelschweißen" bzw. "Schweißen" verwendet.

Die Schweißspannung, die an der Heizwendel anliegt, wird nach einem bekannten Heizwendelschweißverfahren über die Dauer des Schweißvorganges von der Schweißstrom-Versorgungseinheit konstant gehalten. In der Praxis wird die Schweißspannung in der Regel nicht geräteseitig, das heißt an den Enden der Anschlußleitungen auf der Seite der Schweißstrom-Versorgungseinheit, sondern über eine separate Meßleitung heizwendelseitig an den an den Enden der Anschlußleitungen angebrachten Anschlußelementen gemessen. Hierdurch wird der Spannungsabfall, an den Anschlußleitungen umgangen, um die tatsächliche Spannung heizwendelseitig am Ende der Anschlußleitungen zu bestimmen.

Allerdings kann die Qualität der Schweißverbindung durch verschmutzte oder abgenutzte Verbindungselemente bzw. den darin befindlichen Kontakten erheblich reduziert werden, da dann ein Teil der Spannung am Durchgangswiderstand des Kontaktes abfällt. Ein Kontakt mit einem höheren Durchgangswiderstand wird viel stärker aufgeheizt als derjenige mit einem geringeren Durchgangswiderstand. Gleichzeitig empfängt das Fitting eine um die am Kontakt abfallende, geringere Heizleistung, die die Schweißqualität herabsetzt.

Ursache hierfür ist, daß die Schweißstrom-Versorgungseinheit bzw. die darin befindliche Spannungsmeßeinheit die Schweißspannung an den Verbindungselementen der Anschlußleitungen mißt bzw. einregelt und somit den Durchgangswiderstand nicht berücksichtigen kann. Somit liegt an der Heizwendel des Fittings je nach Abnutzungsgrad bzw. Verschmutzungsgrad der Kontakte in den Verbindungselementen der Anschlußleitungen bzw. Anschlußelementen des Heizwendelfittings eine zu geringe Spannung an. Verschmutzungen an Kontakten können beispielsweise Dreck, Staub bzw. eingeflossener Kunststoff aber auch eine Oxidationsschicht sein, die sich auf den Kontakt der Verbindungs- und/oder Anschlußelementen bildet.

Andere Steuerungsverfahren bedienen sich der Leistungen oder des Stromes als Regelparameter oder folgen fest vorgegebenen Regelkurven. In jedem Fall wird immer der exakte Wert der an der Heizwendel angelegten Schweißspannung benötigt.

Ein weiteres, in der Praxis bereits bekanntes Verfahren zum Messen der Schweißspannung an der Heizwendel sieht eine direkte Messung der Temperatur der Heizwendel mittels der Temperaturabhängigkeit des Materials der Heizwendel vor. Es ist offensichtlich, daß hierzu der Widerstand der Heizwendel vor und während des Schweißvorganges mit einer hohen Genauigkeit gemessen werden muß. Ein zu hoher Durchgangswiderstand, der zu dem temperaturabhängig ist, macht ein solches Regelungsverfahren zu ungenau.

In der Praxis ist es schließlich bekannt, an einem Kontakt einer der beiden Anschlußelemente des Heizwendelfittings beim Heizwendelschweißen eine Meßspitze anzusetzen. In diesem Kontakt des Heizwendelfittings ist ein Referenzwiderstand eingebaut, der mit der Meßspitze ausgelesen werden kann. Der so bestimmte Widerstandswert wird über eine Tabelle in eine Schweißzeit umgesetzt. Die Meßspitze ist hier also ein Teil eines automatischen Systems zum Auslesen der Schweißparameter.

Es ist Aufgabe der vorliegenden Erfindung, ein Verfahren sowie eine Vorrichtung der eingangs genannten Art zu schaffen, die eine präzise Erfassung der an der Heizwendel anliegenden Schweißspannung unabhängig von Korrosionseinflüssen usw. ermöglichen.

Hinsichtlich des Verfahrens wird die vorstehende Aufgabe durch die Merkmale des Anspruchs 1 gelöst. In den sich daran anschließenden Ansprüchen 2 bis 4 finden sich vorteilhafte Ausgestaltungen hierzu.

Durch das Abgreifen der Schweißspannung an je einem Schweißstrom-Kontakt der beiden Anschlußelemente des Heizwendelfittings wird ermöglicht, daß Einflüsse, die beispielsweise durch eine Korrosion der Kontaktflächen in den Verbindungselementen der Schweißstrom-Versorgungseinheit hervorgerufen werden, unberücksichtigt bleiben. Damit läßt sich sicher die Schweißspannung an der Heizwendel bestimmen und ein optimaler Schweißvorgang erzielen. Um bei der Messung der Schweißspannung Einflüsse aus den Anschlußleitungen bzw. Verbindungselementen auszuschalten, ist es von Vorteil, wenn die Messung elektrisch isoliert von den Anschlußleitungen durchgeführt wird bzw. die Meßelemente von den Anschlußleitungen bzw. Verbindungselementen elektrisch isoliert sind.

Durch Erfassen der Schweißspannung an dem Schweißstrom-Kontakt der Anschlußelemente und durch Erfassen eines weiteren Spannungswerts an den Anschlußleitungen besteht die Möglichkeit, den Abfall der Spannung infolge des Übergangs- bzw. Durchgangswiderstandes an den Kontakten erfassen zu können.

Um einen sicheren Kontakt bei der Messung zu gewährleisten, wird die Schweißspannung mittels Meßelementen erfaßt, die in Richtung des jeweiligen Kontakts der Anschlußelemente mit einer Kraft reversibel beaufschlagt werden können. Beispielsweise kann diese Kraft eine Federkraft sein. Hierdurch besteht die Möglichkeit, daß eine sich auf dem jeweiligen Kontakt der Anschlußelemente gebildete Ablagerung durch das Meßelement durchstoßen werden kann.

Weiterhin hat sie sich als vorteilhaft erwiesen, wenn die Messung zumindest annähernd stromlos erfolgt, da der Durchgangswiderstand von der Kontaktfläche und dem passierenden (Mess-)Strom abhängig ist. So ist der Durchgangswiderstand, selbst bei einer kleinen Kontaktfläche, mit einem geringen Strom verschwindend gering, während er bei gleicher Kontaktfläche und großem Strom (z. B. dem Schweißstrom) aufgrund der hohen Flächenstromdichte eine entscheidende Größe annimmt. Eine annähernd stromlose Messung kann beispielsweise dadurch geschehen, daß der Eingangswiderstand der Meßeinheit hochohmig ist.

Hinsichtlich der Vorrichtung wird die vorstehende Aufgabe durch die Merkmale des Anspruchs 5 gelöst. In den sich daran anschließenden Ansprüchen 6 bis 10 finden sich vorteilhafte Ausgestaltungen. Im Zusammenhang mit der Heizwendel-Schweißvorrichtung ist zu bemerken, daß damit die gleichen Vorteile erzielbar sind, wie sie vorstehend im Zusammenhang mit den Verfahren erläutert worden sind.

Als weitere Maßnahme zur Sicherstellung eines guten Kontaktes zwischen dem Meßelement und dem Kontakt des jeweiligen Anschlußelementes kann vorgesehen sein, daß das Meßelement eine Meßspitze aufweist, welche in Kontakt mit dem Schweißstrom-Kontakt des Anschlußelementes bringbar ist. Diese Meßspitze unterstützt das Durchdringen von eventuell vorhandenen Ablagerungen an den Schweißstrom-Kontakten der Anschlußelemente.

Weitere vorteilhafte Ausgestaltungen sowie ein Ausführungsbeispiel werden nachstehend anhand der Zeichnungsfiguren erläutert. In diesem Zusammenhang ist zu bemerken, daß sich die bei der Beschreibung verwendeten Begriffe "links", "rechts", "unten" und "oben" auf die Zeichnungsfiguren mit normal lesbaren Bezugszeichen beziehen. Hierbei ist:
- Fig. 1: eine schematische Ansicht einer erfindungsgemäßen Heizwendel-Schweißvorrichtung, und
- Fig. 2: ein Ersatzschaltbild der in Fig. 1 gezeigten Heizwendel-Schweißvorrichtung.

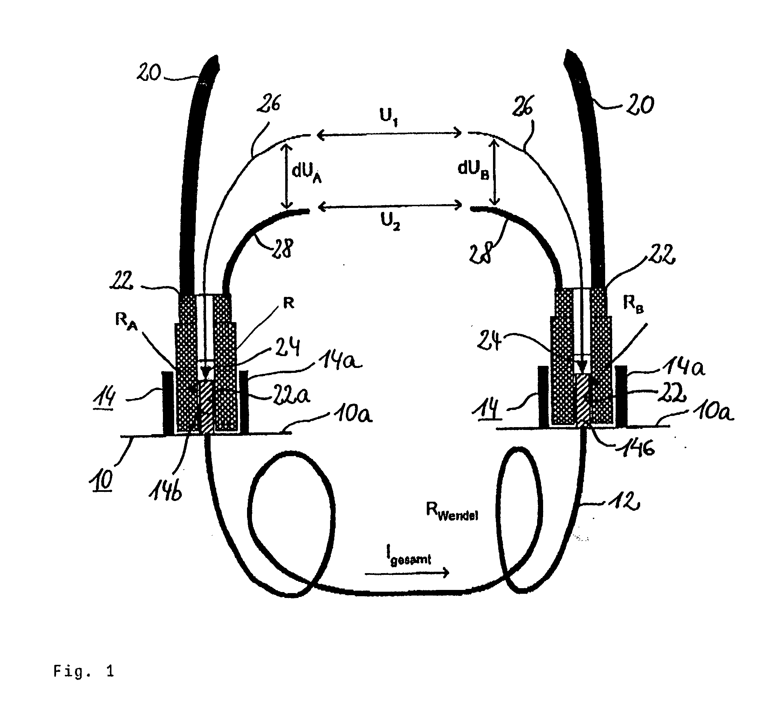

Die Fig. 1 zeigt schematisch den Anschlußbereich eines Heizwendelfittings 10, das aus einem für das Verschweißen von zwei nicht weiter dargestellten Kunststoffrohren geeigneten Kunststoff hergestellt ist. Das Heizwendelfitting 10 besitzt eine Heizwendel 12, von der nur 2 Wendel dargestellt sind und die aus einem Widerstands-Heizdraht gebildet ist. Die beiden Enden der Heizwendel 12 sind durch die Außenwand 10a des Heizwendelfittings 10 hindurchgeführt und enden in zwei Anschlußelementen 14.

Die Anschlußelemente 14 sind als zylindrische Buchsen ausgeführt, die radial nach außen von der Außenwand 10a des Heizwendelfittings 10 abstehen und jeweils ein Rohrstück 14a aufweisen. Zentrisch im Inneren der Rohrstücke 14a ist jeweils eines der Anschlußenden der Heizwendel 12 angeordnet, das dort als Schweißstrom-Kontakt in Form eines Anschlußzapfens 14b, beispielsweise aus Messing, ausgebildet ist. Die radiale Länge der Anschlußzapfen 14b ist gleich, aber kürzer als die radiale Erstreckung der Rohrstücke 14a.

Zum elektrischen Verbinden der Heizwendel 12 mit einer nicht weiter dargestellten Schweißstrom-Versorgungseinheit sind zwei Anschleitungen 20 vorgesehen. Die Anschlußleitungen 20 enden in je einem Verbindungselement 22, das als zylindrischer Stecker ausgeführt ist. Das Verbindungselement 22 besitzt einen Außendurchmesser, der in etwa dem Innendurchmesser eines Anschlußelementes 14 entspricht, so daß das Verbindunsgelement 22 in das entsprechende Anschlußelement 14 von Hand eingeführt und von dort wieder abgezogen werden kann.

Am vorderen freien Ende ist jedes Verbindungselement 22 mit einer Buchse 22a aus einem elektrischleitfähigen Material, wie beispielsweise silberbeschichtetes Messing versehen, in die ein Anschlußzapfen 14b beim Einstecken des Steckers einfährt. Der Innendurchmesser der Buchse 22a entspricht dabei in etwa dem Außendurchmesser des Anschlußzapfens 14b, so daß beim Einfahren des Anschlußzapfens 14b in die Buchse 22a eine elektrische Verbindung zwischen der Schweißstrom-Versorgungseinheit und der Heizwendel 12 hergestellt wird.

Im Inneren jedes Anschlußelements 22 ist jeweils eine elektrisch leitfähige Meßspitze 24 angeordnet, die im dargestellten Ausführungsbeispiel in Kontakt mit der stirnseitigen Endfläche des Anschlußzapfens 14b steht. Jede Meßspitze 24 ist über je eine erste Meßleitung 26 mit einer nicht weiter dargestellten Meßeinheit für die Schweißspannung, die getrennt von der Schweißstrom-Versorgungseinheit oder als Teil von dieser ausgebildet sein kann, elektrisch leitend verbunden. Die Meßeinheit weist einen hochohmigen Eingang auf, so daß die Messung zumindest annährend stromlos erfolgt.

Wie aus Fig. 1 hervorgeht, weist die Meßspitze 24 und die erste Meßleitung 26 keine Verbindung zu dem Verbindunsgelement 22 oder zu der Anschlußleitung 20 auf. Mit anderen Worten ist die Meßspitze 24 und die erste Meßleitung 26 von der jeweiligen Anschlußleitung 20 und dem Verbindungselement 22 durch Luft bzw. einen geeigneten elektrischen Isolator elektrisch isoliert, so daß die Meßspitze 24 nur die Spannung an dem Anschlußzapfen 14b erfaßt. Gegebenenfalls kann diese elektrische Isolierung durch zusätzliche Maßnahmen, wie das Vorsehen von Isoliermaterial zwischen der Meßspitze 24 und/oder der ersten Meßleitung 26 und dem Verbindungselement 22 und/oder der Anschlußleitung 20 noch verstärkt werden.

Weiterhin können optional zwei zweite Meßleitungen 28 vorgesehen sein, die einerseits jeweils mit den beiden Verbindungselementen 22 und andererseits mit der Meßeinheit für die Schweißspannung elektrisch leitend verbunden sind. Mit diesen zweiten Meßleitungen 28 kann daher die Spannung an den Verbindungselementen 22 erfaßt werden.

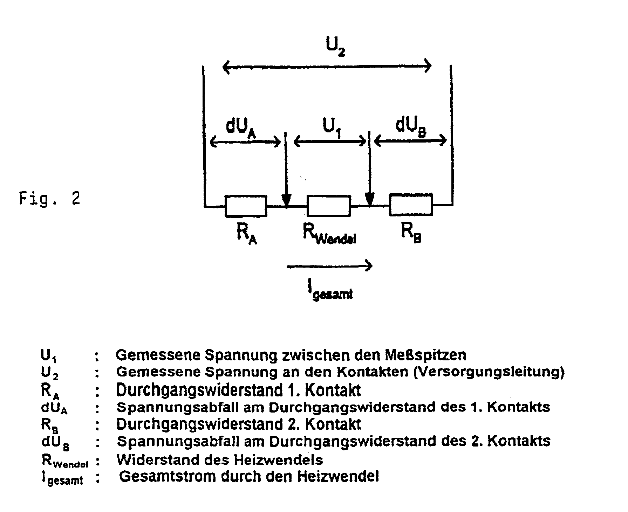

Wie aus Fig. 2 hervorgeht, können die Werte U₁, U₂, dU_{A}, dU_{B} und I_{gesamt} erfaßt werden. Hierbei ist U₁ die gemessene Spannung zwischen den Meßspitzen 24, U₂ die gemessene Spannung an den Verbindungselementen 22, dU_{A} der Spannungsabfall infolge des Durchgangs- bzw. Übergangswiderstand zwischen Buchse 22a und Anschlußzapfen 14b der linken Anschlußverbindung, dU_{B} der Spannungsabfall infolge des Durchgangs- bzw. Übergangswiderstand zwischen Buchse 22a und Anschlußzapfen 14b der rechten Anschlußverbindung und I_{gesamt} der Gesamtstrom durch die Heizwendel 12. Hieraus können die folgenden Werte durch Rechenoperationen mittels Software oder durch eine entsprechend verdrahtete Platine abgeleitet werden:
- Schweißspannung an der Heizwendel:: U_{wendel} = U₁ = U₂-dU_{A}-dU_{B}
- Widerstand des Heizwendels:: R_{wendel} = U_{wendel}/I_{gesamt}=U₁/I_{gesamt}

Damit sind die relevanten Werte ausreichend bestimmt. Des weiteren ergeben sich aus den Daten:
- Verlustleistung an den Kontakten:: P_{A+B} = (dU_{A}+dU_{B})*I_{gesamt}
- Durchgangswiderstand:: R_{A+B} = (dU_{A}+dU_{B})/I_{gesamt}

Die durch den erfindungsgemäßen Aufbau einer Heizwendel-Schweißvorrichtung neu zur Verfügung stehenden Werte lassen eine genauere Regelung des Schweißvorganges zu. Zudem können die Verluste infolge der Durchgangs- bzw. Übergangswiderstände zwischen jeweils einer Buchse 22a und einem Anschlußzapfen 14b durch eine höhere Spannung oder längere Schweißzeit in gewissen Grenzen kompensiert werden. Wird allerdings eine bestimmte Verlustleistung überschritten, so muß zur Qualitätsicherung der Schweißvorgang als fehlerhaft abgebrochen werden.

Im Falle der direkten Temperatursteuerung macht die Anordnung der Meßspitzen 24 das Verfahren erst möglich, da der Durchgangs- bzw. Übergangswiderstand ohne diese direkt in die Regelungstemperatur eingehen würde.

Es ist noch zu bemerken, daß als Anschlußelemente auch Klemmanschlüsse, Vierkantzapfen und ähnliches Verwendung finden kann.

## Patentansprüche

1. Verfahren zum Messen der Schweißspannung an einer Heizwendel (12) eines Heizwendelfittings (10), bei dem eine Schweißstrom-Versorgungseinheit über Anschlussleitungen (20) und Verbindungselemente (22) mit den Anschlusselementen (14) des Heizwendelfittings (10) verbunden und anschließend die Schweißspannung mittels einer Messeinheit erfasst wird,
**dadurch gekennzeichnet, dass** die Schweißspannung an je einem Schweißstrom-Kontakt (14b) der beiden Anschlusselemente (14) des Heizwendelfittings (10) elektrisch isoliert von den Anschlussleitungen (20) sowie den Verbindungselementen (22) abgegriffen wird.

2. Verfahren nach Anspruch 1,
**dadurch gekennzeichnet, daß** die Schweißspannung an dem Schweißstrom-Kontakt (14b) der Anschlußelemente (14) und ein weiterer Spannungswert an den Anschlußleitungen (20) abgegriffen wird.

3. Verfahren nach Anspruch 1 oder 2,
**dadurch gekennzeichnet, daß** die Schweißspannung mittels Meßelementen (24) erfaßt wird, die in Richtung des Schweißstrom-Kontakts (14b) der Anschlußelemente (14) mit einer Kraft reversibel beaufschlagt werden.

4. Verfahren nach einem der Ansprüche 1 bis 3,
**dadurch gekennzeichnet, daß** die Messung zumindest annährend stromlos erfolgt.

5. Heizwendel-Schweißvorrichtung, insbesondere zum Durchführen des Verfahrens nach einem der Ansprüche 1 bis 4, mit wenigstens einer Schweißstrom-Versorgungseinheit, mit mindestens zwei mit der Schweißstrom-Versorgungseinheit verbundenen Anschlussleitungen (20), die jeweils ein Verbindungselement (22) aufweisen und über die die Schweißstrom-Versorgungseinheit mit Anschlusselementen (14) mindestens eines Heizwendelfittings (10) lösbar verbindbar ist, und mit einer Messeinheit zum Erfassen zumindest der Schweißspannung, von der je eine erste Messleitung (28) zu dem Verbindungselement (22) einer der Anschlussleitungen (20) führt,
**dadurch gekennzeichnet, dass** jedes Verbindungselement (22) wenigstens ein Messelement (24) aufweist, das jeweils mit der ersten Messleitung (26) verbunden ist und das zum Erfassen der Schweißspannung elektrisch isoliert von der Anschlussleitung (20) und dem Verbindungselement (22) in elektrisch leitende Berührung mit dem Schweißstrom-Kontakt (14b) eines Anschlusselementes (14) des Heizwendelfittings (10) bringbar ist.

6. Heizwendel-Schweißvorrichtung nach Anspruch 5,
**dadurch gekennzeichnet, daß** das Meßelement (24) gegen den Schweißstrom-Kontakt (14b) des Anschlußelements (14) drängbar ist.

7. Heizwendel-Schweißvorrichtung nach Anspruch 6,
**dadurch gekennzeichnet, daß** das Meßelement (24) mittels einer Federkraft gegen den Schweißstrom-Kontakt (14b) des Anschlußelements (14) drängbar ist.

8. Heizwendel-Schweißvorrichtung nach einem der Ansprüche 5 bis 7,
**dadurch gekennzeichnet, daß** das Meßelement (24) eine Meßspitze aufweist, welche in Berührung mit dem Schweißstrom-Kontakt (14) des Anschlußelements (14) bringbar ist.

9. Heizwendel-Schweißvorrichtung nach einem der Ansprüche 5 bis 8,
**dadurch gekennzeichnet, daß** eine zweite Meßleitung (28) vorgesehen ist, die einerseits mit der Meßeinheit und andererseits mit den Verbindungselementen (22) elektrisch leitend verbunden ist.

10. Heizwendel-Schweißvorrichtung nach Anspruch 9,
**dadurch gekennzeichnet, daß** die Anschlußleitungen und die ersten sowie zweiten Meßleitungen (26, 28) jeweils zu einem Kabelstrang zusammengefaßt sind.

## Claims

1. Method for measuring the welding voltage at a heating coil (12) of a heating coil fitting (10), whereby a welding current supply unit is connected with the terminal elements (14) of the heating coil fitting (10) by way of connecting lines (20) and fasteners (22) and the welding voltage is then detected by means of a measuring unit,
**characterized in that** the welding voltage is taken off at a welding current contact (14b) of each of the two terminal elements (14) electrically isolated from the connecting lines (20) and the fasteners (22).

2. Method according to Claim 1,
**characterized in that** the welding voltage is taken off at the welding current contact (14b) of the terminal elements (14) and a further voltage level at the connecting lines (20).

3. Method according to Claim 1 or 2,
**characterized in that** the welding voltage is detected by means of measuring elements (24), which have a force applied reversibly in the direction of the welding current contact (14b) of the terminal elements (14).

4. Method according to one of Claims 1 to 3,
**characterized in that** the measurement is made at least approximately currentlessly.

5. Heating coil welding equipment, in particular for executing the method according to one of Claims 1 to 4, with at least one welding current supply unit, with at least two connecting lines (20) connected with the welding the welding current supply unit, each having a fastening (22) and by way of which the welding current supply unit can be separably connected with terminal elements (14) of at least one heating coil fitting (10), and with a measuring unit for detecting at least the welding voltage, from which an initial measuring line (28) leads to the fastener (22) of one of the connecting lines (20),
**characterized in that** each fastener (22) has at least one measuring element (24), each of which is connected with the initial measuring line (26) and which can be brought into electrically conductive contact with the welding current contact (14b) of a terminal element (14) of the heating coil fitting (10) for detection of the welding voltage electrically isolated from the connecting line (20) and the fastening (22).

6. Heating coil welding equipment according to Claim 5,
**characterized in that** the measuring element (24) can be pushed against the welding current contact (14b) of the terminal element (14).

7. Heating coil welding equipment according to Claim 6,
**characterized in that** the measuring element (24) can be pushed against the welding current contact (14b) of the terminal element (14) by spring force.

8. Heating coil welding equipment according to one of Claims 5 to 7,
**characterized in that** the measuring element (24) has a test prod that can be brought into contact with the welding current contact (14b) of the terminal element (14).

9. Heating coil welding equipment according to one of Claims 5 to 8,
**characterized in that** there is a second measuring line (28), which is firstly connected with the measuring unit and secondly electrically conductive with the fasteners (22).

10. Heating coil welding equipment according to Claim 9,
**characterized in that** the connecting lines and the first and second measuring lines (26, 28) are each combined into one strand.

## Revendications

1. Procédé de mesure de la tension de soudage sur un filament chauffant (12) d'une prise de filament chauffant (10), pour lequel une unité d'alimentation en courant de soudage est reliée par des câbles de branchement (20) et des éléments de connexion (22) aux éléments de branchement (14) de la prise de filament chauffant (10) et la tension de soudage est ensuite saisie au moyen d'une unité de mesure,
**caractérisé en ce que** la tension de soudage est saisie à un contact de courant de soudage (14b) respectivement des deux éléments de branchement (14) de la prise de filament chauffant (10), de façon isolée électriquement des câbles de branchement (20) ainsi que des éléments de connexion (22).

2. Procédé selon la revendication 1,
**caractérisé en ce que** la tension de soudage est saisie au contact de courant de soudage (14b) des éléments de branchement (14) et **en ce qu'**une autre valeur de tension est saisie aux câbles de branchement (20).

3. Procédé selon la revendication 1 ou 2,
**caractérise en ce que** la tension de soudage est saisie au moyen d'éléments de mesure (24) qui sont soumis réversiblement à une force dans la direction du contact de courant de soudage (14b).

4. Procédé selon l'une quelconque des revendications 1 à 3,
**caractérisé en ce que** la mesure s'effectue au moine à pou près sans courant.

5. Dispositif de soudage à filament chauffant, en particulier pour exécuter le procédé selon l'une quelconque des revendications 1 à 4, avec au moins une unité d'alimentation en courant de soudage, avec au moins deux câbles de branchement (20) reliés à l'unité d'alimentation en courant de soudage, qui comprennent chacun un élément de connexion (22) et par lesquels l'unité d'alimentation en courant de soudage peut être reliée de manière démontable aux éléments de branchement (14) d'au moins une prise de filament chauffant (10), et avec une unité de mesure pour la saisie d'au moins la tension de soudage, de laquelle respectivement une première ligne de mesure (28) mène vers l'élément de connexion (22) d'un des câbles de branchement (20),
**caractérisé en ce que** chaque élément de connexion (22) comporte au moins un élément de mesure (24), qui est relié respectivement à la première ligne de mesure (26) et qui, pour la saisie de la tension de soudage, électriquement isolé du câble de branchement (20) et de l'élément de connexion (22), peut être mis en contact conducteur électrique avec le contact de courant de soudage (14b) d'un élément de branchement (14) de la prise de filament chauffant (10).

6. Dispositif de soudage à filament chauffant selon la revendication 5,
**caractérisé en ce que** l'élément de mesure (24) peur être poussé contre le contact de courant de soudage (14b) de l'élément de branchement (14).

7. Dispositif de soudage à filament chauffant selon la revendication 6,
**caractérisé en ce que** l'élément de mesure (24) peur être poussé au moyen de la force d'un ressort contre le contact de courant de soudage (14b) de l'élément de branchement (14).

8. Dispositif de soudage à filament chauffant selon l'une quelconque des revendications 5 à 7,
**caractérisé en ce que** l'élément de mesure (24) comprend une pointe de mesure qui peut être amenée en contact avec le contact de courant de soudage (14b) de l'élément de branchement (14).

9. Dispositif de soudage à filament chauffant selon l'une quelconque des revendications 5 à 8.
**caractérisé en ce qu'**une deuxième ligne de mesure (28) est prévue, qui est reliée de manière à conduire l'électricité, d'un côté à l'unité de mesure et de l'autre côté aux éléments de connexion (22).

10. Dispositif de soudage à filament chauffant selon la revendication 9,
**caractérisé en ce que** les câbles de branchement et les premières ainsi que les deuxièmes lignes de mesure (26, 28) sont respectivement réunies en un faisceau de câbles.
